# EUROPEAN PATENT APPLICATION

(11) **EP 2 091 143 A2**
(43) Date of publication of application: **19.08.2009**
(21) Application number: 09152842.2
(22) Date of filing: 13.02.2009
(51) Int. Cl.: H03D 7/16

(54) **Conversion architecture for residual spur avoidance**

(30) Priority: 15.02.2008 US 32537
(71) Applicant: TEKTRONIX, INC., Beaverton, OR 97077-0001 (US)
(72) Inventor: Li, Litong, Portland, OR 97229 (US); Dalebroux, Donald J., Vernonia, OR 97064 (US); Larrick, Ronald J., Beaverton, OR 97008 (US)
(74) Representative: Schurack, Eduard F.

(57) **Abstract**

A method and apparatus for residual spur avoidance is disclosed. One embodiment comprises a method of generating a first local oscillator signal, mixing the first local oscillator signal with a radio frequency signal to generate an intermediate frequency signal, filtering the intermediate frequency signal at a band-pass frequency, mixing the filtered intermediate frequency signal with a second local oscillator signal having a first frequency offset from the band-pass frequency to generate an output intermediate frequency signal, and switching the second local oscillator signal to a second frequency offset to avoid a spur generated from the first frequency offset, wherein the second frequency offset is the opposite sign but same magnitude offset from the band-pass frequency.

## Description

### BACKGROUND

The present invention relates to radio frequency receivers, and more particularly to a method of residual spur avoidance in a multi-conversion radio frequency receiver.

A multi-conversion radio frequency receiver may use multiple local oscillators when up-converting and down-converting a signal of interest. These separate local oscillators create sum and difference harmonic mixing products between themselves using the various nonlinear elements, primarily mixers and amplifiers, in the receiver. The amplitude of these harmonic mixing products depends on the conversion efficiency of the various elements at the harmonic mixing product frequencies. As a first local oscillator (LO) is tuned to convert assorted radio frequency (RF) input frequencies to a first intermediate frequency (IF), the unintended harmonic mixing products of the first LO frequency with a second LO frequency may fall within an IF filter bandwidth. When this occurs in a spectrum analyzer instrument, the energy from the unwanted LO harmonic mixing product, or residual spur, appears as a real RF signal on a final spectral display.

What is desired is a method of residual spur avoidance that avoids unwanted harmonic mixing products from multiple local oscillators in a multi-conversion radio frequency receiver.

### SUMMARY

Accordingly, various embodiments for residual spur avoidance in a multi-conversion radio frequency receiver are described below in the Detailed Description. For example, one embodiment comprises a superheterodyne receiver with a first tunable local oscillator, a mixer to mix the first local oscillator signal with an input RF signal to generate an IF signal, a band-pass filter to filter the IF signal at a band-pass frequency, a second set of two local oscillators having the same frequency offset above and below the IF signal, and a mixer to down convert the IF signal using one of the second local oscillators. At frequency combinations of the first and second local oscillators that would generate a spurious response, the superheterodyne receiver can switch to the other of the second local oscillators to generate the same down converted IF frequency and to avoid the spurious response. Combinations of problem frequencies may be stored and accessed at run time to select the second local oscillator offset that provides better spurious response avoidance.

This Summary is provided to introduce concepts in a simplified form that are further described below in the Detailed Description. This Summary is not intended to identify key features or essential features of the claimed subject matter, nor is it intended to be used to limit the scope of the claimed subject matter. Furthermore, the claimed subject matter is not limited to implementations that solve any or all disadvantages noted in any part of this disclosure.

### BRIEF DESCRIPTION OF THE DRAWINGS

Fig. 1 shows a block diagram view of a prior art superheterodyne receiver architecture having multiple frequency conversions that convert a high frequency signal to an IF signal.
Fig. 2 shows a block diagram view of an embodiment superheterodyne receiver architecture for residual spur avoidance according to the present disclosure.
Fig. 3 shows a process flow depicting an embodiment of a method for residual spur avoidance.

### DETAILED DESCRIPTION

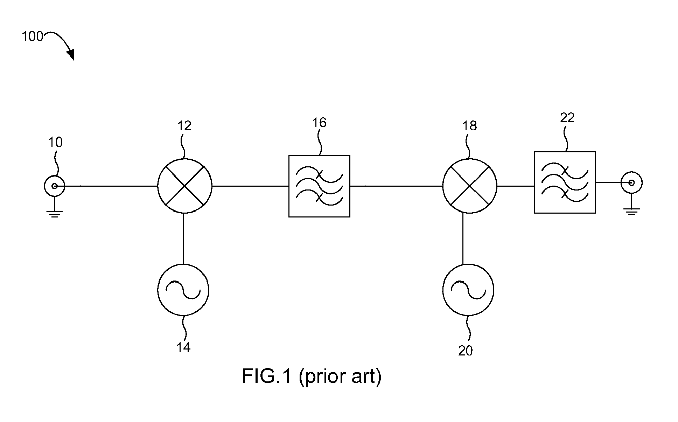

Fig. 1 illustrates a prior art superheterodyne receiver 100 that provides multiple frequency conversions to down convert a high frequency signal to an IF signal, as further described in U.S. Pat. No. 6,785,527. At certain frequency combinations of the multiple conversions, a superheterodyne receiver may generate a spurious response at the IF frequency. For example, residual spurious response may be due to finite isolation of an IF filter that filters LO signals between conversion stages.

Superheterodyne receiver 100 mixes an input RF signal 10 with a signal generated by a local oscillator 14 to generate a first IF signal. The first IF signal is band-pass filtered and then mixed with a signal from a second local oscillator to down convert to a second IF signal. In a specific example, a spurious response may be generated when the first LO 14 is tuned to 4.225 GHz and the second LO 20 is tuned to 4.15 GHz. At this frequency, the first LO 14 will generate a second harmonic at 8.45 GHz. If this harmonic passes through a first IF filter 16, the harmonic can mix with a second harmonic of the second LO 20 that is oscillating at 8.3 GHz to generate an unwanted 150 MHz signal at the same frequency as the output IF. Residual spurs may occur at numerous combinations of LO harmonic frequencies.

In the approach used in U.S. Pat. No. 6,785,527 a conversion spur is avoided by predicting where conversion spurs may occur and retuning the second LO 20 when the harmonic mixing product falls within an IF filter bandwidth of a first one of the local oscillators. This approach essentially shifts the first band-pass filter shape within the second band-pass filter 22 and changes the second IF signal frequency to move the spurious response outside of the band-pass frequencies of the filter. Unfortunately, there is a limit on the amount of the second IF frequency shift that can be applied while still providing anti-aliasing of the IF signal to an A/D converter. Further, every time the filter shape is adjusted, the filter may need to be normalized to provide a flat response. Additionally, the second LO will need to be tunable in small steps and will increase phase noise over a fixed frequency second LO.

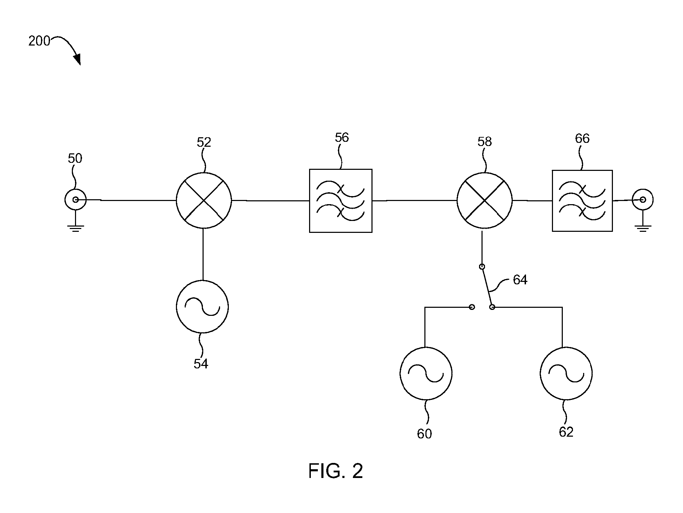

Fig. 2 shows a block diagram view of an embodiment superheterodyne receiver 200 for residual spur avoidance according to the present disclosure. The embodiment superheterodyne receiver 200 provides a switchable second conversion that can mix an IF signal with a local oscillator that is either a frequency offset above or the same frequency offset below the IF signal. In this way, when a spurious response is generated at one combination of frequencies for a first and a second conversion, then the combination of frequencies can be changed by switching the second local oscillator to the opposite offset from the IF signal. Other embodiments are not so limited, for example, additional offsets may be used within the principles of this disclosure, some embodiments may use additional conversions, etc.

Referring in detail to Fig. 2, superheterodyne receiver 200 mixes an input RF signal 50 with a signal generated by a local oscillator 54 to generate a first IF signal. The first IF signal is band-pass filtered 56 and then mixed 58 with a signal from a second local oscillator 62 to down convert to a second IF signal. The second IF signal is then band-pass filtered 66 to provide an output IF signal at a specific frequency.

Superheterodyne receiver 200 further includes a switch 64 and another second local oscillator 60. In some embodiments, second local oscillator 62 and second local oscillator 60 are offset from a first IF frequency the same amount, with one of the second local oscillators high-side injected to the first IF signal at mixer 58, and the other second local oscillator is low-side injected to the first IF signal at mixer 58. Therefore, a spurious response that would be generated at a combination of harmonics between the first and second local oscillators can be avoided by switching between the second local oscillators, thus generating IF output signals at the same frequency while moving the spurious response outside of the pass bands of filter 58.

In the example explained with reference to Fig. 1, when the first LO is tuned to 4.225 GHz it will have a second harmonic at 8.45 GHz. In the receiver architecture shown in Fig. 2, the second local oscillators 60 and 62 are set at 4.15 GHz and at 3.85 GHz. In his architecture, the second local oscillator may have a harmonic at 8.3 GHz with high-side injection or a harmonic at 7.7 GHz with low-side injection. Therefore, to avoid the spur that would be generated at 150 MHz between the 8.3 GHz harmonic of the high-side injected local oscillator, the second local oscillator and be switched to the 3.85 GHz signal, and thus the spurious response will be generated at 750MHz and outside of the range of the 150MHz IF.

In some embodiments, this 2nd LO may be switched at multiple frequencies at which a spurious response would occur. For example, combinations of problem frequencies may be stored in a table, and for frequency combinations that would generate a spurious response, the second local oscillator can be switched to the opposite side offset. In some combinations, a spurious response may be generated by both second local oscillators. In these situations, the second local oscillator that generates the smaller spurious response may be chosen. In some embodiments, this approach may be further applied to subsequent stages of conversion. In yet another embodiment, a superheterodyne receiver may switch between high and low-side injection to generate a second IF in combination with adjusting the effective filter shape of the second IF filter to provide more control for avoiding spurious responses. By switching the second conversion between a high-side and a low-side injection, the center frequency of the second IF remains the same, but the pass-band is inverted. After digitization of the pass-band, the second IF signal can again be inverted, for example using a digital signal processor (DSP).

It will be appreciated that the embodiments described herein may be implemented, for example, via computer-executable instructions or code, such as programs, stored on a computer-readable storage medium and executed by n instrument receiver or other suitable computing device. Generally, programs include routines, objects, components, data structures, and the like that perform particular tasks or implement particular abstract data types. As used herein, the term "program" may connote a single program or multiple programs acting in concert, and may be used to denote applications, services, or any other type or class of program. Likewise, the terms "computer" and "computing device" as used herein include any device that electronically executes one or more programs, including, but not limited to a superheterodyne receiver such as a spectrum analyzer, or any other suitable RF signaling devices.

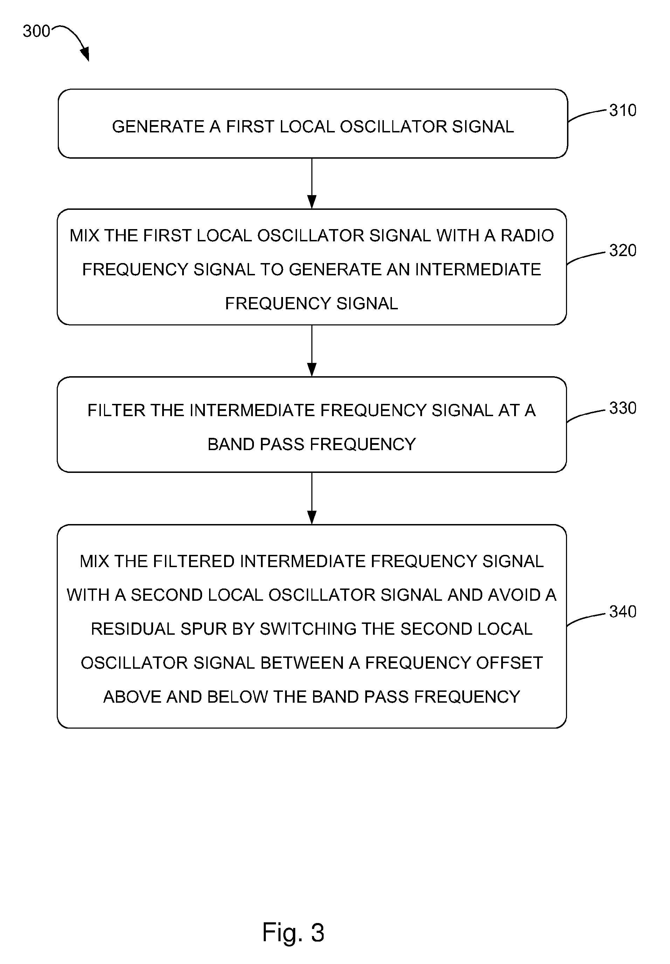

Continuing with Fig. 3, a method 300 for residual spur avoidance is illustrated. First, as indicated in block 310, a signal is generated using a tunable local oscillator. The local oscillator signal is then mixed with an input signal to generate an IF signal, as illustrated in block 320. For an input signal that may be any frequency from DC up to a certain frequency, the local oscillator may cover a corresponding frequency range in order to generate an IF signal of the same frequency for any input frequency. Other embodiments are not so limited. For example, a multi-conversion radio frequency receiver may utilize separate circuitry to heterodyne input signals of different frequency ranges.

Next, method 300 comprises filtering the intermediate frequency signal at a band-pass frequency, as indicated at 330. Then, in some embodiments, the filtered intermediate frequency signal is mixed with a second local oscillator signal that may be switched between frequency offsets above and below the band-pass frequency (step 340). In this manner, when a spurious response is generated using one of the frequency offsets, the second local oscillator signal may be switched to the opposite offset to avoid the residual spurious response. In some embodiments, this second local oscillator signal may be generated by a set of two local oscillators, and the signal may be generated by switching from one of the two local oscillators to the other of the two local oscillators.

It will further be understood that the configurations and/or approaches described herein are exemplary in nature, and that these specific embodiments or examples are not to be considered in a limiting sense, because numerous variations are possible. The specific routines or methods described herein may represent one or more of any number of processing strategies. As such, various acts illustrated may be performed in the sequence illustrated, in other sequences, in parallel, or in some cases omitted. Likewise, the order of any of the above-described processes is not necessarily required to achieve the features and/or results of the embodiments described herein, but is provided for ease of illustration and description. The subject matter of the present disclosure includes all novel and non-obvious combinations and sub-combinations of the various processes, systems and configurations, and other features, functions, acts, and/or properties disclosed herein, as well as any and all equivalents thereof.

## Claims

1. A method of spur avoidance in a multi-conversion radio frequency receiver having coupled in series a first local oscillator, an intermediate frequency filter, and a switchable set of second local oscillators, for analyzing an input radio frequency signal, the method comprising:
generating a first local oscillator signal;
mixing the first local oscillator signal with a radio frequency signal to generate an intermediate frequency signal;
filtering the intermediate frequency signal at a band-pass frequency;
mixing the filtered intermediate frequency signal with a second local oscillator signal to generate an output signal, wherein the second local oscillator signal has an offset from the band-pass frequency, and the offset is either a high-side offset above the band-pass frequency or a low-side offset below the band-pass frequency; and
switching the second local oscillator signal between the offsets to avoid a spurious response in the output signal.

2. The method of claim 1, wherein the high-side offset and the low-side offset are generated from two local oscillators.

3. The method of claim 1, further comprising:
accessing a table of problem frequency combinations between the first local oscillator signal and the second local oscillator signal; and
switching between offsets in the second local oscillator signal according to the table of problem frequencies to avoid multiple spurious responses.

4. The method of claim 1, wherein the first local oscillator signal is at a higher frequency than the input radio frequency signal.

5. A computer-readable medium comprising instructions executable by a computing device to reduce a residual spurious response, the instructions being executable to perform a method comprising:
generating a first local oscillator signal;
mixing the first local oscillator signal with a radio frequency signal to generate an intermediate frequency signal;
filtering the intermediate frequency signal at a band-pass frequency;
mixing the filtered intermediate frequency signal with a second local oscillator signal having a first frequency offset from the band-pass frequency to generate an output signal; and
switching the second local oscillator signal to a second frequency offset to avoid a spur generated from the first frequency offset, wherein the first and second frequency offsets cause the computing device to generate the same frequency output signal.

6. The computer-readable medium of claim 5, wherein the first frequency offset and the second frequency offset are generated from two local oscillators.

7. The computer-readable medium of claim 5, further comprising instructions for:
accessing a table of problem frequency combinations between the first local oscillator signal and the second local oscillator signal; and
switching between the first frequency offset and the second frequency offset in the second local oscillator signal according to the table of problem frequencies to avoid multiple spurious responses.

8. The computer-readable medium of claim 5, wherein the first local oscillator signal is at a higher frequency than the input radio frequency signal.

9. An instrument receiver architecture comprising:
input circuitry to receive a radio frequency signal;
a first local oscillator coupled with a first mixer, the mixer to combine an output from the first local oscillator with the radio frequency signal to generate first intermediate frequency signal; and
two second local oscillators coupled to a second mixer, the second mixer to receive the first intermediate frequency signal and combine it with an output signal from either of the two second local oscillators to generate a second intermediate frequency signal, wherein one second local oscillator output signal has an offset above the first intermediate frequency and the other second local oscillator output signal has the same magnitude offset below the first intermediate frequency; and
a switch coupled to the pair of second local oscillators and the second mixer, the switch to change the second local oscillator output signal provided to the second mixer to avoid a spurious response.

10. The instrument receiver architecture in claim 9, further comprising a memory to store a table of problem frequency combinations between the first local oscillator and the second local oscillators, the instrument receiver to switch between second local oscillators according to the table of problem frequencies to avoid multiple spurious responses.

11. The instrument receiver architecture of claim 9, wherein the first local oscillator signal is at a higher frequency than the input radio frequency signal.
